# EUROPEAN PATENT SPECIFICATION

(11) **EP 2 752 883 B1**
(45) Date of publication and mention of the grant of the patent: **20.07.2016**
(21) Application number: 12827459.4
(22) Date of filing: 31.08.2012
(51) Int. Cl.: H01L 31/04

(54) **THIN FILM SOLAR CELL MODULE AND ITS PRODUCTION PROCESS**
DÜNNSCHICHT-SOLARZELLENMODUL UND VERFAHREN ZU SEINER HERSTELLUNG
MODULE DE CELLULE SOLAIRE À FILM MINCE ET PROCÉDÉ DE FABRICATION DUDIT MODULE

(30) Priority: 31.08.2011 JP 2011189723
(43) Date of publication of application: 09.07.2014
(73) Proprietor: Asahi Glass Company, Limited, Tokyo 100-8405 (JP)
(72) Inventor: MASUMO, Kunio, Tokyo 100-8405 (JP); HIGASHI, Seiji, Tokyo 100-8405 (JP)
(74) Representative: Müller-Boré & Partner Patentanwälte PartG mbB
(86) International application number: PCT/JP2012/072231
(87) International publication number: WO 2013/031978

(56) References cited:
- WO-A1-2005/027229
- JP-A- 2001 060 703
- JP-A- 2001 196 615
- JP-A- 2001 196 615
- JP-A- 2005 244 073
- US-A- 5 348 589

## Description

### TECHNICAL FIELD

The present invention relates to a thin film solar cell module and its production process. More specifically, it relates to an integrated structure thin film solar cell module having a plurality of thin film solar cells connected in series, and its production process.

### BACKGROUND ART

As a thin film solar cell module which is a photoelectric conversion element, depending upon the type of the photoelectric conversion layer, an amorphous silicone (a-Si) type, a polycrystalline silicone type, etc. are used, and in such a thin film silicone solar cell, a transparent electrically conductive oxide film is used as a transparent electrode layer on the incident light side. This transparent electrically conductive oxide film is required to have low resistance, to be highly transparent and to have high light scattering performance, so as to increase the photoelectric conversion efficiency.

A thin film solar cell module has a structure comprising a substrate such as a glass substrate, and a transparent electrode layer, a photoelectric conversion layer and a rear electrode layer formed in this order on the substrate. Documents US 5 348 589 A and JP 2001 196615A describe thin film solar cell devices.

When the area of a thin film solar cell module is increased, the resistance of the transparent electrode layer on the light-receiving side is increased, and by the resulting power loss, the efficiency as a module tends to be reduced. Thus, by an integrated structure having a plurality of thin film solar cells formed on a substrate, connected with each other in series, the resistance of the transparent electrode layer on the light-receiving side is decreased to reduce the power loss, and a decrease in the efficiency as a module can be reduced even when the module has a large area.

A process for producing an integrated structure thin film solar cell module roughly includes a cell preparation step of preparing an integrated structure having a plurality of thin film solar cells connected in series, and a modularization step of forming a rear protective film and the like to the integrated structure obtained by the above process to form a solar cell module. The cell preparation step includes a thin film forming step comprising formation of a transparent electrode layer, formation of a photoelectric conversion layer, formation of a rear electrode layer, and the like, and a patterning step of forming a dividing groove in the thin films to divide the cell into a plurality of cells (Non-Patent Document 1).

In the patterning step, patterning of the transparent electrode layer by forming a dividing groove in the transparent electrode layer, patterning of the photoelectric conversion layer by forming a dividing groove in the photoelectric conversion layer, and patterning of the rear electrode layer and the photoelectric conversion layer by forming a dividing groove in the rear electrode layer and the photoelectric conversion layer, are carried out. By the rear electrode layer being embedded in the dividing groove formed in the photoelectric conversion layer, the rear electrode layer embedded in the dividing groove and the transparent electrode layer are electrically connected, whereby an integrated structure having a plurality of cells connected in series is achieved.

In the patterning step, a dividing groove can be formed selectively in a specific thin film by selecting light beam in a wavelength region to be absorbed by a thin film to be treated, and due to excellent dimensional accuracy of the dividing groove to be formed, a laser scribing method employing laser light is preferably used.

An overcoat film is formed on the transparent electrode layer in some cases to protect a transparent electrically conductive oxide film as the transparent electrode layer from the heat or the plasma impact at the time of forming the photoelectric conversion layer. As an overcoat film to be formed for such a purpose, a film containing titanium oxide (TiO₂) as the main component is preferably used.

However, since titanium oxide (TiO₂) is an insulating material, in a case where it is used as an overcoat film, it is necessary to impart electrical conductivity e.g. by forming a film having oxygen defect or doping the film with a metal having a valency different from that of titanium.

### PRIOR ART DOCUMENTS

### NON-PATENT DOCUMENT

Non-Patent Document 1: "Hakumakutaiyoukoudenchi no kiso to ouyou; Kankyou ni yasashii taiyoukou hatsuden no atarashii tenkai (Fundamentals and Application of Thin Film Solar Cell: New Development of Environmentally-Friendly Photovoltaic Generation)", edited by Photovoltaic Power Generation Technology Research Association, published by Ohmsha, Ltd., March 20, 2001

### DISCLOSURE OF INVENTION

### TECHNICAL PROBLEM

As described above, each of an integrated structure thin film solar cell module and an overcoat film formed on a transparent electrically conductive layer is preferred by itself to improve the efficiency of a module.

However, the present inventors have found that if they are used in combination, the power loss by the resistance is rather increased, whereby the efficiency of a module is decreased.

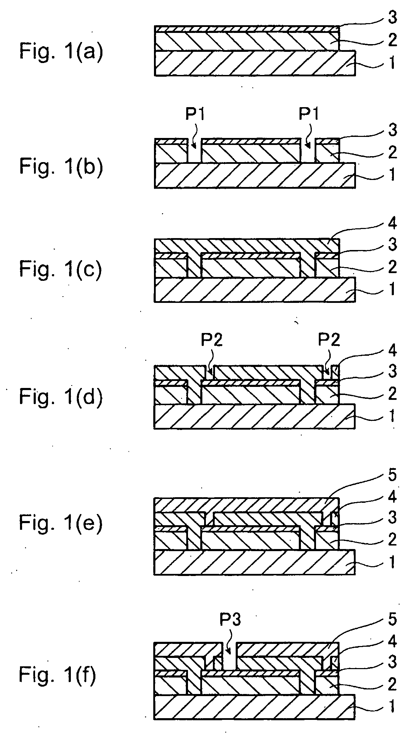

Figs. 1 (a) to (f) are drawings illustrating a cell preparation step in a process for producing an integrated structure thin film solar cell module.

Fig. 1 (a) illustrates a state where a transparent electrode layer 2 is formed on a substrate 1 such as a glass substrate, and an overcoat film 3 is formed on the transparent electrode layer 2.

Fig. 1(b) illustrates a state after patterning of the transparent electrode layer 2 is carried out. In this embodiment, since the overcoat film 3 is formed on the transparent electrode layer 2, the overcoat film 3 is patterned together with the transparent electrode layer 2, and a first dividing groove P1 is formed in the transparent electrode layer 2 and the overcoat film 3.

Fig. 1(c) illustrates a state where a photoelectric conversion layer 4 is formed on the overcoat film 3. Here, the photoelectric conversion layer 4 is also embedded in the first dividing groove P1.

Fig. 1(d) illustrates a state after patterning of the photoelectric conversion layer 4 is carried out. A second dividing groove P2 is formed on the photoelectric conversion layer 4.

Fig. 1 (e) illustrates a state where a rear electrode layer 5 is formed on the photoelectric conversion layer 4. Here, the rear electrode layer 5 is also embedded in the second dividing groove P2.

Fig. 1(f) illustrates a state after patterning of the rear electrode layer 5 and the photoelectric conversion layer 4 is carried out. A third dividing groove P3 is formed in the rear electrode layer 5 and the photoelectric conversion layer 4.

For patterning of the transparent electrode layer 2 and the overcoat film 3 shown in Fig. 1(b), patterning of the photoelectric conversion layer 4 shown in Fig. 1(d) and patterning of the rear electrode layer 5 and the photoelectric conversion layer 4 shown in Fig. 1(f), a laser scribing method is employed.

The present inventors have conducted extensive studies on an increase in the power loss by the resistance of an integrated structure thin film solar cell module obtained by the cell preparation step shown in Figs. 1 (a) to (f) and as a result, found that at the time of patterning of the photoelectric conversion layer 4 shown in Fig. 1(d), the overcoat film 3 is heat-denatured by heating in the laser scribing method, whereby the resistance of the overcoat film 3 is increased. Since adjacent thin film solar cells are maintained by the rear electrode layer 5 formed in the second dividing groove of the thin film solar cell module and the overcoat film 3 being electrically connected, the power loss is increased by an increase in the resistance of the overcoat film 3 by heat denaturation, and the efficiency as a module is decreased.

Under these circumstances, an object of the present invention is to provide an integrated structure thin film solar cell module of which an increase in the resistance by heating at the time when the overcoat film is laser scribed, and which has an improved efficiency as a module, and its production process.

### SOLUTION TO PROBLEM

To achieve the above objects, the present invention provides a process for producing a thin film solar cell module comprising a plurality,of thin film solar cells each comprising a substrate, and a transparent electrically conductive oxide film, an overcoat film, a photoelectric conversion layer and a rear electrode layer laminated in this order on the substrate, the layers on the substrate being divided by a plurality of dividing grooves in a direction substantially vertical to the substrate, and the adjacent thin film solar cells being electrically connected in series, the process comprising: a step of forming the transparent electrically conductive oxide film on the substrate, a step of forming the overcoat film in the transparent electrically conductive oxide film, and a step of pattering the transparent electrically conductive oxide film and the overcoat film by forming a first dividing groove on the transparent electrically conductive oxide film and the overcoat film by a laser scribing method to divide the transparent electrically conductive oxide film and the overcoat film; a step of forming the photoelectric conversion layer in the first dividing groove and on the overcoat film, and a step of patterning the photoelectric conversion layer by forming a second dividing groove in the photoelectric conversion layer by a laser scribing method to divide the photoelectric conversion layer; and a step of forming the rear electrode layer in the second dividing groove and on the photoelectric conversion layer, and a step of patterning the rear electrode layer and the photoelectric conversion layer by forming a third dividing groove in the rear electrode layer and the photoelectric conversion layer by a laser scribing method to divide the rear electrode layer and the photoelectric conversion layer; wherein the step of pattering the photoelectric conversion layer is carried out so that the bottom of the second dividing groove is located in the transparent electrically conductive oxide film; and wherein the overcoat film is a film containing titanium oxide the main component and tin oxide. The above respective steps are carried out in the above order.

In the process for producing a thin film solar cell module of the present invention, it is preferred that the power density of laser light in the laser scribing method to form the second dividing groove in the photoelectric conversion layer is higher than 0.1 mW/µm².

Further, the rear electrode layer and the transparent electrically conductive oxide film are electrically connected in the second dividing groove.

In the process for producing a thin film solar cell module of the present invention, it is preferred that the transparent electrically conductive oxide film is a tin oxide film containing fluorine as a dopant.

In the process for producing a thin film solar cell module of the present invention, it is preferred that the thickness of the transparent electrically conductive oxide film is from 400 to 1,200 nm.

In the process for producing a thin film solar cell module of the present invention, it is preferred that for formation of the transparent electrically conductive oxide film, an atmospheric pressure CVD method is used.

In the overcoat film, the tin oxide is preferably tin oxide having oxygen defect.

In the overcoat film, the tin oxide is preferably tin oxide containing fluorine as a dopant.

In the process for producing a thin film solar cell module of the present invention, it is preferred that the thickness of the overcoat film is from 10 to 100 nm.

In the process for producing a thin film solar cell module of the present invention, it is preferred that for formation of the overcoat film, an atmospheric pressure CVD method is used.

In the process for producing a thin film solar cell module of the present invention, it is preferred that the photoelectric conversion layer contains a layer (p-i-n-layer) having a p-layer, an i-layer and a n-layer formed in this order.

In the process for producing a thin film solar cell module of the present invention, it is preferred that for formation of the photoelectric conversion layer, a plasma CVD method is used.

In the process for producing a thin film solar cell module of the present invention, it is preferred that the rear electrode layer contains as the main component silver, aluminum or an alloy thereof.

In the process for producing a thin film solar cell module of the present invention, it is preferred that the thickness of the rear electrode layer is from 100 to 300 nm.

In the process for producing a thin film solar cell module of the present invention, it is preferred that for formation of the rear electrode layer, a sputtering method is used.

In this specification, " to " used to show the range of the numerical values is used to include the numerical values before and after it as the lower limit value and the upper limit value, and unless otherwise specified, the same applies hereinafter.

In the process for producing a thin film solar cell module of the present invention, it is preferred that the energy distribution at a portion irradiated with the laser light at the time of forming the second dividing groove, is substantially Gaussian distribution.

In the process for producing a thin film solar cell module of the present invention, it is preferred that in the step of patterning the transparent electrically conductive oxide film and the overcoat film, in the step of patterning the photoelectric conversion layer and in the step of patterning the rear electrode layer and the photoelectric conversion layer, a laser light source at an oscillation wavelength in the vicinity of 1,064 nm is used.

The present invention further provides a thin film solar cell module which comprises a plurality of thin film solar cells each comprising a substrate, and a transparent electrically conductive oxide film, an overcoat film, a photoelectric conversion layer and a rear electrode layer laminated in this order on the substrate, the layers on the substrate being divided by dividing grooves, and the adjacent thin film solar cells being electrically connected in series, wherein the transparent electrically conductive oxide film and the overcoat film are divided by a first dividing groove, the photoelectric conversion layer is embedded in the first dividing groove, the photoelectric conversion layer is divided by a second dividing groove, the rear electrode layer is embedded in the second dividing groove, the rear electrode layer and the photoelectric conversion layer are divided by a third dividing groove, and the bottom of the second dividing groove is located in the transparent electrically conductive oxide film, wherein the overcoat film is a film containing titanium oxide as the main component and containing tin oxide.

The thin film solar cell module of the present invention is characterized in that the rear electrode layer and the transparent electrically conductive oxide film are electrically connected in the second dividing groove.

### ADVANTAGEOUS EFFECTS OF INVENTION

In the present invention, even when the overcoat film is heat-denatured by laser scribing and its resistance is increased, the rear electrode layer formed in the second dividing groove of the thin film solar cell module and the transparent electrically conductive oxide film are electrically connected. Thus, electrical connection in series of adjacent thin film solar cells is maintained, whereby the power loss by the resistance can be suppressed, and therefore, an efficiency as a module is improved.

### BRIEF DESCRIPTION OF DRAWINGS

Figs. 1 (a) to (f) are drawings illustrating a cell preparation step in a process for producing a conventional integrated structure thin film solar cell module.
Figs. 2(a) to (c) are drawings schematically illustrating a second dividing groove formed by a step of patterning a photoelectric conversion layer, Fig. 2(a) illustrates a second dividing groove formed by a conventional method, and Figs. 2(b) and (c) illustrate a second dividing groove formed by the process of the present invention.
Fig. 3 is a graph illustrating I-V curves of thin film solar cell modules in Example and Comparative Examples 1 and 2.
Fig. 4 is a view schematically illustrating a sample constitution for measurement of the contact resistance in a second dividing groove P2 of a thin film solar cell module.

### DESCRIPTION OF EMBODIMENTS

Now, the present invention will be described.

In the process for producing a thin film solar cell module of the present invention, the same procedure as in the cell preparation step in a process for producing an integrated structure thin film solar cell module shown in Figs. 1 (a) to (f) is carried out except that the step of patterning a photoelectric conversion layer is different in the after-mentioned points.

That is, as shown in Fig. 1(a), on a substrate 1 such as a glass substrate, as a transparent electrode layer 2, a transparent electrically conductive oxide film is formed, and on the transparent electrode layer 2 (transparent electrically conductive oxide film), an overcoat film 3 is formed.

### <Substrate>

The substrate 1 is not necessarily in a flat plate form, and may be curved or may be in another form. The substrate 1 may, for example, be a glass substrate, a ceramic substrate, a plastic substrate or a metal substrate. The substrate 1 is preferably a transparent substrate excellent in the translucency, and is preferably a glass substrate in view of the strength and the heat resistance. As the glass substrate, a transparent glass substrate made of colorless and transparent soda lime silicate glass, aluminosilicate glass, borate glass, lithium aluminosilicate glass, quartz glass, borosilicate glass, alkali-free glass or another glass may be used.

In a case where a glass substrate is used as the substrate 1 of the thin film solar cell module, the thickness of the glass substrate is preferably from 0.2 to 6.0 mm. Within such a range, the glass substrate has high strength and has a high transmittance.

Further, the substrate 1 preferably has a high transmittance, for example, a transmittance of at least 80%, in a wavelength region of from 350 to 800 nm. Further, it preferably is sufficiently insulating and has high chemical and physical durability.

In a case of a glass substrate made of glass containing sodium such as soda lime silicate glass or a glass substrate made of glass having a low alkali content, in order to minimize diffusion of alkali components from the glass to the transparent electrically conductive oxide film formed thereon, an alkali barrier layer such as a silicon oxide film, an aluminum oxide film or a zirconium oxide film may be applied to the glass substrate surface.

Further, on the surface of the glass substrate, a layer to reduce the difference in the refractive index between the surface of the glass substrate and a layer formed thereon, may further be formed. By forming such a layer, reflection at the interface between the glass substrate and a layer formed thereon can be prevented.

The alkali barrier layer formed on the soda lime glass substrate is preferably a SiO₂ film, a mixed oxide film of Si0₂ and SnO₂, or a multilayer film having a Si0₂ film and another oxide film laminated, and its thickness (in the case of a multilayer film, total thickness) is preferably from 20 to 100 nm. When the thickness is within such a range, reflection and absorption of transmitted light from the glass substrate can be controlled. The multilayer film may, for example, be a film having a TiO₂ film and a Si0₂ film laminated in this order on the soda lime glass substrate, and their thicknesses are respectively preferably from 5 to 20 nm and from 10 to 40 nm: Particularly, the total thickness of the alkali barrier layer is preferably from 30 to 60 nm.

### <Transparent electrically conductive oxide film>

The transparent electrically conductive oxide film formed as the transparent electrode layer 2 is required to be transparent in the visible region and to have electrical conductivity.

In order that the transparent electrically conductive oxide film is highly transparent in the visible region, its refractive index is preferably from 1.8 to 2.2, more preferably from 1.9 to 2.1 at a wavelength of from 400 to 800 nm.

Further, with respect to the electrical conductivity, the sheet resistance of the transparent electrically conductive oxide film is preferably from 8 to 20f2/o, more preferably from 8 to 12Ω/□.

The transparent electrically conductive oxide film is preferably a tin oxide film containing fluorine as a dopant (hereinafter sometimes referred to as "fluorine-doped tin oxide film"), since such a film satisfies the above refractive index and sheet resistance. The fluorine-doped tin oxide film contains fluorine preferably in an amount of from 0.01 to 15 mol%, more preferably from 0.1 to 10 mol%, further preferably from 0.5 to 9 mol%, by mol% to tin oxide.

The transparent electrically conductive oxide film has a thickness of preferably from 400 to 1200 nm, more preferably from 400 to 800 nm, further preferably from 500 to 750 nm.

For formation of the transparent electrically conductive oxide film, an atmospheric pressure CVD method is preferably used from such reasons as a low apparatus cost and a high film deposition rate.

### <Overcoat film>

As the overcoat film 3, it is preferred to use a titanium oxide-based film containing, as the metal component in the film 3, titanium as the main component, i.e. a film containing titanium oxide as the main component.

A titanium oxide-based film, i.e. an overcoat film containing titanium oxide as the main component is preferred as an overcoat film to protect the transparent electrically conductive oxide film (fluorine-doped tin oxide film) as the transparent electrode layer 2, from the heat and the plasma impact at the time of forming the photoelectric conversion layer 4, due to such characteristics as excellent resistance to reduction by hydrogen plasma as compared with the fluorine-doped tin oxide film used as the transparent electrically conductive tin oxide film.

Further, a titanium oxide-based film has translucency, and has a refractive index within a range of from the refractive index of the transparent electrically conductive oxide film (fluorine-doped tin oxide film) used as the transparent electrode layer 2 and the refractive index of the photoelectric conversion layer 4 having a composition described hereinafter respectively as the lower limit and the upper limit, and thus it also functions as a refractive index-adjusting layer to adjust the difference in the refractive index between them and can improve the light trapping efficiency.

However, since titanium oxide is an insulating material, in order that the overcoat film 3 has electrical conductivity, tin oxide is preferably contained in the titanium oxide film. Here, as the tin oxide, preferred is tin oxide having favorable electrical conductivity (low resistance).

In this specification, "containing as the main component" means the content of the component being at least 50%.

One of specific examples of the tin oxide having favorable electrical conductivity is tin oxide having oxygen deficient. Here, the proportion of the oxygen deficient is preferably at most 20%. When the proportion of the oxygen deficient is at most 20%, an increase of absorption of light by the overcoat film 3 can be suppressed, and the amount of incident light to the photoelectric conversion layer 4 can be secured.

Another specific example of the tin oxide having favorable electrical conductivity is tin oxide containing fluorine as a dopant. Here, the amount of fluorine doped is preferably less than 1.0 by the molar ratio of F/Ti in the raw materials of a F-containing compound and a Ti-containing compound used for film deposition for the overcoat film (hereinafter sometimes referred to as the F/Ti molar ratio in the raw materials), in the overcoat film 3. If the amount of fluorine doped is at least 1.0 by the F/Ti molar ratio in the raw materials, the transparent electrically conductive oxide film may be damaged by the etching effect by fluorine at the time of forming the overcoat film 3.

Further, if the amount of fluorine doped is at least 1.0 by the F/Ti molar ratio in the raw materials, the overcoat film 3 itself is also subjected to the etching effect by fluorine, and as a result, problems such as a decrease in the film deposition rate of the overcoat film 3, and a decrease in the denseness of the film and thus a decrease n the electrical conductivity of the overcoat film, may occur.

The amount of fluorine doped is preferably from 0.0001 to 0.5, more preferably from 0.001 to 0.3, further preferably from 0.001 to 0.25, by the F/Ti molar ratio in the raw materials in the overcoat film 3.

The overcoat film in the present invention also has the above-described function as a refractive index-adjusting layer, since tin oxide is present in the titanium oxide-based film containing, as the metal component in the film, titanium as the main component. Accordingly, reflection at the interface between the transparent electrically conductive oxide film as the transparent electrode layer 2 and the photoelectric conversion layer 4 can be prevented. Further, electrical connection at the interface between the transparent electrically conductive oxide film as the transparent electrode layer 2 and the photoelectric conversion layer can be improved, and the output voltage of the thin film solar cell module can be improved.

The content of tin oxide in the titanium-oxide-based overcoat film 3 containing tin oxide, is preferably at least 0.05 by the molar ratio (Sn/(Sn+Ti) molar ratio) of tin to the total amount of tin and titanium in the overcoat film 3, with a view to improving the electrical conductivity and securing favorable contact resistance. The Sn/(Sn+Ti) molar ratio in the overcoat film 3 is preferably at least 0.05 and at most 0.6, in order to satisfy all of the improvement in the electrical conductivity, securance of favorable contact resistance and adjustment of the refractive index. The Sn/(Sn+Ti) molar ratio in the overcoat film 3 is more preferably at least 0.1 and at most 0.5, further preferably at least 0.2 and at most 0.5.

The overcoat film 3 has a thickness of preferably at least 10 nm and at most 100 nm, with a view to fulfillling a function required for an overcoat film, to suppress deterioration of the transparent electrically conductive oxide film as the transparent electrode layer 2 by the heat or the plasma impact at the time of forming the photoelectric conversion layer 4.

In a case where the overcoat film 3 is made to fulfill a function as a refractive index-adjusting layer, the thickness of the overcoat film 3 is more preferably at least 20 nm and at most 60 nm, further preferably at least 25 nm and at most 50 nm, particularly preferably at least 30 nm and at most 50 nm.

In order that the overcoat film 3 fulfills a function as a refractive index-adjusting layer, the refractive index of the overcoat film 3 is preferably from 2.1 to 2.7, more preferably from 2.2 to 2.5 at a wavelength of from 400 to 800 nm.

As described above, the refractive index of the transparent electrically conductive oxide film as the transparent electrode layer 2 covered with the overcoat film 3 is preferably from 1.8 to 2.2, more preferably from 1.9 to 2.1 at a wavelength of from 400 to 800 nm.

On the other hand, the refractive index of the photoelectric conversion layer 4 to be formed on the overcoat film 3 varies depending upon the structure and the material of the photoelectric conversion layer 4, but is preferably within a range of from 2.8 to 4.5 at a wavelength of from 400 to 800 nm in any case.

When the refractive index of the overcoat film 3 is within the above range, it is within a range of from the refractive index of the transparent electrically conductive oxide film as the transparent electrode layer 2 and the refractive index of the photoelectric conversion layer 4 respectively as the lower limit and the upper limit, and accordingly the overcoat film 3 functions as a refractive index-adjusting layer and can suppress reflection of light resulting from the difference in the refractive index between the transparent electrically conductive oxide film and the photoelectric conversion layer, whereby the light introduction efficiency to the photoelectric conversion layer will be improved.

For formation of the overcoat film 3 having the above-described composition, an atmospheric pressure CVD method is preferably used from such reasons as low apparatus cost and a high film deposition rate.

Then, as shown in Fig. 1(b), a step of patterning the transparent electrically conductive oxide film as the transparent electrode layer 2 and the overcoat film 3, by forming a first dividing groove P1 in the transparent electrically conductive oxide film as the transparent electrode layer 2 and the overcoat film 3 by a laser scribing method is carried out.

In the step of patterning the transparent electrically conductive oxide film as the transparent electrode layer 2 and the overcoat film 3, laser light in a wavelength region which is absorbed by such films, for example, laser light having a wavelength in the vicinity of 1,064 nm is used. Using as a laser light source, a light source at a wavelength in the vicinity of 1,064 nm, for example, an infrared laser light source at a wavelength of 1,064 nm, and the substrate 1 is irradiated with laser light by applying laser light adjusted to have desired power and spot diameter to a portion on which a first dividing groove P1 is to be formed, in a direction vertical to the substrate in a pulse form, to form a first dividing groove P1, thereby to divide the transparent electrically conductive oxide film as the transparent electrode layer 2 and the overcoat film 3 into a desired shape. Specifically, for example, a pulse laser light having a spot diameter of from 20 to 50 µm is applied at a repetition frequency of about 10 kHz while the irradiation portion is moved from about 5 to 50 µm in a constant direction (that is, a round irradiation spot of the laser light is moved with a distance of about its diameter in a direction in parallel with the substrate; the same applies hereinafter), to form a linear first dividing groove P1 in the form of a straight line having a width of from about 20 to about 50 µm. This procedure is repeatedly carried out at intervals of from about 5 to about 20 mm in a direction of another edge of the substrate 1 to divide the transparent electrically conductive oxide film as the transparent electrode layer 2 and the overcoat film 3 into strips having a width of from about 5 to about 20 mm.

Irradiation with the laser light may be carried out from the front surface side of the overcoat film 3 or may be carried out from the rear side of the substrate 1 through the substrate 1.

The energy distribution at the portion irradiated with the laser light may be Gaussian distribution such that the light is merely focused, or may be a so-called top hat profile such that the energy distribution is in a square form.

Then, as shown in Fig. 1(c), the photoelectric conversion layer 4 is formed in the first dividing groove P1 and on the overcoat film 3.

The photoelectric conversion layer 4 can be widely selected from photoelectric conversion layers used for a thin film solar cell module. As an example, a single structure photoelectric conversion layer consisting of 3 layers of a p-layer, an i-layer and a n-layer formed in this order may be mentioned. As a material of the p-layer, hydrogenated amorphous silicon carbide (a-SiC:H) may be mentioned. As a material of the i-layer, hydrogenated amorphous silicon (a-Si:H), crystalline silicon (c-Si), microcrystalline silicon (µc-Si) or hydrogenated amorphous silicon germanium (a-SiGe:H) may be mentioned. Further, as a material of the n-layer, hydrogenated amorphous silicon (a-Si:H) or microcrystalline silicon (µc-Si) may be mentioned. Among them, preferred is a single structure consisting of 3 layers (hereinafter sometimes referred to as a p-i-n-layer of a-Si) of an a-SiC:H layer as the p-layer, an a-Si:H layer as the i-layer and an a-Si:H layer as the n-layer formed in this order.

Further, as another example, a tandem structure electromotive layer having another p-i-n-layer further formed on the p-i-n-layer of a-Si is preferably used. More preferably, the layer to be formed on the p-i-n-layer of a-Si is a tandem structure electromotive layer consisting of 3 layers of an a-Si:H layer as the p-layer, a microcrystalline Si layer as the i-layer and an a-Si:H layer as the n-layer formed in this order, or three layers of an a-Si:H layer as the p-layer, an a-SiGe:H layer as the i-layer and an a-Si:H layer as the n-layer formed in this order.

The photoelectric conversion layer 4 having the above structure may be formed by a plasma CVD method. Conditions at the time of forming the photoelectric conversion layer 4 may properly be selected from conditions employed at the time of forming a photoelectric conversion layer of a thin film solar cell module depending upon the type of the photoelectric conversion layer 4 to be formed.

The thickness of the photoelectric conversion layer varies depending upon the electromotive layer to be formed, and is properly selected depending upon the type.

Further, the thicknesses of the p-layer and the n-layer formed by the plasma CVD method are preferably within a range of from 5 to 15 nm, and the thickness of the i-layer is preferably within a range of from 100 to 400 nm. Further, the thickness of the microcrystalline Si layer in the tandem structure is preferably from 500 to 3,000 nm.

Then, as shown in Fig. 1 (d), a step of patterning the photoelectric conversion layer 4 by forming a second dividing groove P2 in the photoelectric conversion layer 4 by a laser scribing method is carried out. However, in the present invention, the step of patterning the photoelectric conversion layer 4 is carried out so that the bottom of the second dividing groove P2 is located within the transparent electrically conductive oxide film as the transparent electrode layer 2.

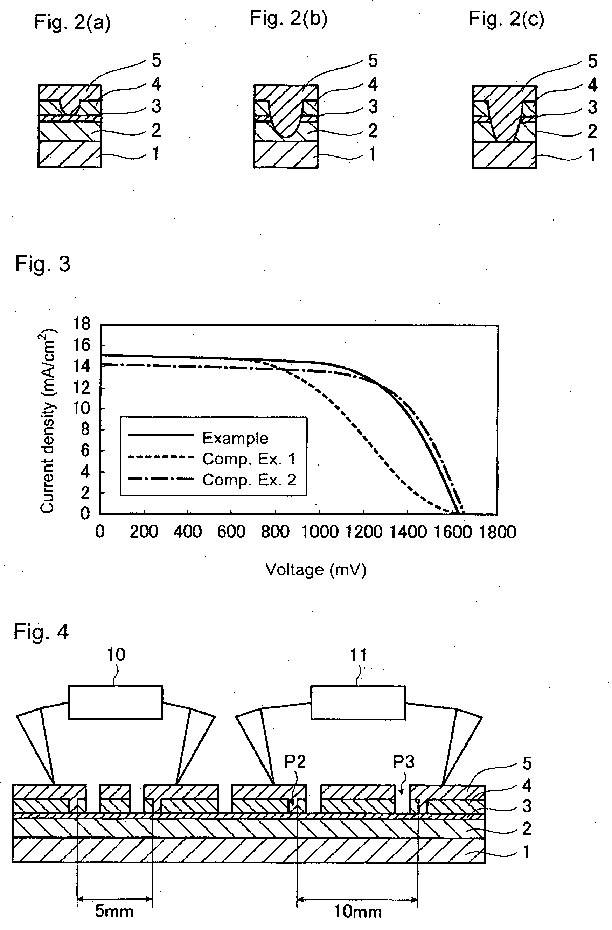

Figs. 2(a) to (c) are drawings schematically illustrating a second dividing groove formed by the step of patterning a photoelectric conversion layer, Fig. 2(a) illustrates a second dividing groove formed by a conventional method, and Figs. 2(b) and (c) illustrates a second dividing groove formed by the process of the present invention. For easy understanding of the effects of the present invention, a state after formation of the rear electrode layer subsequently carried out is illustrated.

As shown in Fig. 2(a), by a conventional method, the bottom of the second dividing groove (the bottom of the groove) formed by the step of patterning the photoelectric conversion layer 4 is located on the overcoat film 3, and the rear electrode layer 5 embedded in the second dividing groove and the overcoat film 3 are electrically connected.

As described above, the overcoat film 3 containing titanium oxide as the main component protects the transparent electrically conductive oxide film as the transparent electrode layer 2 from the heat and the plasma impact at the time of forming the photoelectric conversion layer 4, since it is excellent in the resistance to reduction by hydrogen plasma as compared with the fluorine-doped tin oxide film used as the transparent electrically conductive tin oxide film. However, since it is a titanium oxide-based film containing, as the metal component in the film, titanium as the main component, the overcoat film 3 is heat-denatured by the heat energy by irradiation of the photoelectric conversion layer 4 with the laser light in the step of patterning the photoelectric conversion layer 4, and the resistance of the overcoat film 3 is increased.

In an integrated structure thin film solar cell module, by electrical connection of the rear electrode layer 5 embedded in the second dividing groove and the overcoat film 3, electrical connection in series of the adjacent thin film solar cells is formed, and accordingly the power loss is increased by an increase in the resistance of the overcoat film 3 by heat denaturation, and the efficiency as a module is decreased.

On the other hand, in the present invention, as shown in Figs. 2(b) and (c), the bottom of the second dividing groove formed by the step of patterning the photoelectric conversion layer 4 is located in the transparent electrically conductive oxide film as the transparent electrode layer 2, and accordingly the rear electrode layer 5 embedded in the second dividing groove and the transparent electrically conductive oxide film as the transparent electrode layer 2 are electrically connected.

In Fig. 2(c), the bottom of the second dividing groove formed by the step of patterning the photoelectric conversion layer 4 is located at the interface between the transparent electrically conductive oxide film as the transparent electrode layer 2 and the substrate 1, and such a state is also regarded as a state where the bottom of the second dividing groove is located in the transparent electrically conductive oxide film as the transparent electrode layer 2.

The transparent electrically conductive oxide film as the transparent electrode layer 2, which is a fluorine-doped tin oxide film, will not be heat-denatured by the heat energy by irradiation of the photoelectric conversion layer 4 with laser light in the step of patterning the photoelectric conversion layer 4, and its resistance will not be increased.

In the thin film solar cell module of the present invention, by electrical connection of the rear electrode layer 5 embedded in the second dividing groove and the transparent electrically conductive oxide film as the transparent electrode layer 2, electrical connection in series of the adjacent thin film solar cells is formed, and accordingly the power loss by the resistance can be suppressed, whereby the efficiency as a module will be improved.

In the step of patterning the photoelectric conversion layer 4, laser light in a wavelength region which is absorbed by the photoelectric conversion layer 4, for example, laser light having a wavelength of 532 nm which is the second higher harmonics of a laser light source at a wavelength in the vicinity of 1,064 nm is used. The substrate 1 is irradiated with laser light by applying laser light adjusted to have desired power and spot diameter to a portion on which the second dividing groove P2 is to be formed in a pulse form, to form a second dividing groove P2 thereby to divide the photoelectric conversion layer 4 into a desired shape. Here, in order that the bottom of the second dividing groove is located in the transparent electrically conductive oxide film as the transparent electrode layer 2, the power of the laser light used is increased as compared with the conditions for the step of patterning the photoelectric conversion layer 4 by a conventional method, i.e. conditions for a case where the bottom of the second dividing groove is located on the overcoat film 3 as shown in Fig. 2(a). For example, in the after-mentioned Example, the power (laser outpour) of the laser light was about 3.5 times as compared with Comparative Example 1 in which the bottom of the second dividing groove was located on the overcoat film 3, to bring the bottom of the second dividing groove to be in the transparent electrically conductive oxide film as the transparent electrode layer 2. Particularly, in a case where laser light having a wavelength of 532 nm is used in the laser scribing method for forming the second dividing groove in the photoelectric conversion layer, the power density of the laser light is preferably higher than 0.1 mW/µm².

Further, at the time when the substrate 1 is irradiated with the laser light, by increasing the distance of movement of the irradiation portion in a direction in parallel with the surface of the substrate, the second dividing groove to be formed has irregularities in its side surfaces. Therefore, it is expected that the area of a portion where the rear electrode layer 5 embedded in the second dividing groove and the transparent electrically conductive oxide film as the transparent electrode layer 2 are electrically connected is increased, and the power loss by the resistance will further be suppressed.

The step of patterning the photoelectric conversion layer 4 may be carried out basically in the same manner as the step of patterning the transparent electrically conductive oxide film as the transparent electrode layer 2 and the overcoat film 3 except that the wavelength and the power of the laser light are as described above. However, as shown in Fig. 1(d), the position of the second dividing groove P2 should be shifted from the first dividing groove P1 shown in Fig. 1(b). The distance between the adjacent second dividing groove P2 and first dividing groove P1 is preferably from about 50 to about 150 µm.

Then, the rear electrode layer 5 is formed in the second dividing groove and on the photoelectric conversion layer 4 as shown in Fig. 1(e).

The rear electrode layer 5 contains silver, aluminum or an alloy thereof (silver alloy, aluminum alloy) as the main component. Preferably, a metal film containing at least 95 mol% of crystalline silver in the film is used. By use of crystalline silver for the metal film of the rear electrode layer 5, light transmitted through the photoelectric conversion layer 4 can be reflected and the reflected light can be returned to the photoelectric conversion layer 4 again, thus leading to an improvement in the photoelectric conversion efficiency.

The metal film may contain palladium and/or gold as its component. In the case of a metal film containing silver as the main component, the contents of palladium and gold in the film are respectively preferably from 0.3 to 5 mol%, more preferably from 0.3 to 3 mol% to the total amount with silver. Further, in the case of a layer made of silver alone, the total content of impurities is preferably at most 1 mol%.

The rear electrode layer 5 having the above composition may be formed by a sputtering method. For example, in a case where a metal film containing crystalline silver in an amount of at least 95 mol% in the film is to be formed as the rear electrode layer 5, it may be formed by sputtering in an inert gas atmosphere using as a target a metal containing at least 95 mol% of Ag (hereinafter referred to asAg-based metal).

Further, between the photoelectric conversion layer 4 and the rear electrode layer 5, a contact-improving layer to improve the contact property between them may be formed. Further, in a case where a contact-improving layer is formed between them, the contact-improving layer preferably has lower specific resistance and absorption coefficient. Specifically, the specific resistance is preferably at most 1×10⁻²Ω·m, more preferably at most 5×10⁻³Ω·m. When the specific resistance of the contact-improving layer is within such a range, the electromotive force photoelectrically converted by the photoelectric conversion layer 4 can be transferred to the rear electrode layer 5 without being reduced. The absorption coefficient is preferably at most 5×10³ cm⁻¹, more preferably at most 2×10³cm⁻¹ in a wavelength region of from 500 to 800 nm. When the absorption coefficient of the contact-improving layer is within such a range, the light transmitted through the photoelectric conversion layer 4 can be transmitted to the rear electrode layer 5 without being absorbed.

A material of the contact-improving layer which satisfies the above specific resistance and absorption coefficient preferably contains zinc oxide (ZnO) as the main component, and the film preferably contains Zn in an amount of at least 90 atomic% of all the metal components. More preferably, such a layer containing zinc oxide as the main component and further containing gallium (Ga) or aluminum (Al) is used. By Ga or Al, the electrically conductive electron density will be increased, and by the function of Ga or Al as a dopant to zinc oxide, the electrical conductivity of the entire contact-improving layer will be improved.

Further, the content of Ga or Al is preferably from 0.3 to 10 mol%, more preferably from 0.3 to 5 mol% to the total amount with Zn. Within such a range, an increase in the absorption coefficient of the contact-improving layer by an excessive improvement in the electrical conductivity can be prevented. Further, in a case of a zinc oxide layer containing Ga or Al, it may contain impurities, and the total content of impurities is preferably at most 1 mol%.

The contact-improving layer having the above composition may be formed by a sputtering method. For example, in a case where a layer containing zinc oxide as the main component and further containing gallium (Ga) is to be formed as the contact-improving layer, it may be formed by sputtering in an inert gas atmosphere using as a target zinc oxide doped with Ga (hereinafter referred to as GZO).

Then, as shown in Fig. 1(f), a step of patterning the rear electrode layer 5 and the photoelectric conversion layer 4 to form a third dividing groove P3 in the rear electrode layer 5 and the photoelectric conversion layer 4 by a laser scribing method, is carried out. In a case where the contact-improving layer is formed between the photoelectric conversion layer 4 and the rear electrode layer 5, the third dividing groove P3 is formed also in the contact-improving layer.

In the step of patterning the rear electrode layer 5 and the photoelectric conversion layer 4, a laser light in a wavelength region which is absorbed by the photoelectric conversion layer 4, for example, laser light having a wavelength of 532 nm which is the second higher harmonics of a laser light source at a wavelength in the vicinity of 1,064 nm is used. The substrate 1 is irradiated with laser light by applying laser light adjusted to have desired power and spot diameter to a portion where the second dividing groove P3 is to be formed in a pulse form, to form the second dividing groove P3 thereby to divide the rear electrode layer 5 and the photoelectric conversion layer 4 into a desired shape.

Here, since the rear electrode layer 5 does not transmit the laser light, irradiation with the laser light is carried out from the rear side of the substrate 1 through the substrate 1. By the photoelectric conversion layer 4 absorbing the laser light, the third dividing groove P3 is formed in the rear electrode layer 5 and the photoelectric conversion layer 4. Accordingly, the power of the laser light used should be high as compared with the conditions in the step of patterning the photoelectric conversion layer 4 by a conventional method, i.e. conditions for a case where the bottom of the second dividing groove is located on the overcoat film 3 as shown in Fig. 2(a). For example, in the after-mentioned Example, the power of the laser light was about 1.1 times as compared with Comparative Example 1 in which the bottom of the second dividing groove was located on the overcoat film 3, to form the third dividing groove P3 in the rear electrode layer 5 and the photoelectric conversion layer 4.

The step of patterning the rear electrode layer 5 and the photoelectric conversion layer 4 may be carried out basically in the same manner as the step of patterning the photoelectric conversion layer 4 except that the direction of irradiation with the laser light and the power are as described above. However, as shown in Fig. 1(f), the position of the third dividing groove P3 should be shifted from the first dividing groove P1 shown in Fig. 1(b) and the second dividing groove P2 shown in Fig. 1(d). Specifically, the first dividing groove P1, the second dividing groove P2 and the third dividing groove P3 should be arranged in this order. Further, the distance between the adjacent second dividing groove P2 and third dividing groove P3 is preferably from about 50 to about 150 µm.

### EXAMPLES

Now, the present invention will be described in further detail. However, it should be understood that the present invention is by no means restricted to such specific Examples.

### EXAMPLE

Using as a substrate 1 a soda lime glass substrate (300 mm × 300 mm × 3.9 mm) having an antireflection film having a TiO₂ film and a Si0₂ film laminated formed thereon, a fluorine-doped tin oxide film was formed as a transparent electrically conductive oxide film (transparent electrode layer 2) on the antireflection film of the substrate 1 by an atmospheric pressure CVD method. Formation of the fluorine-doped tin oxide film by the atmospheric pressure CVD method was carried out as follows.

On the soda lime glass substrate heated to 550°C by an electric heater, tin tetrachloride, water vapor and hydrofluoric acid were sprayed from a nozzle to form a fluorine-doped tin oxide film having a thickness of 700 nm.

Then, an overcoat film 3 containing titanium oxide as the main component and containing, as tin oxide having favorable electrical conductivity, tin oxide containing fluorine as a dopant, was formed on the fluorine-doped tin oxide film by an atmospheric pressure CVD method.

Formation of the overcoat film 3 by the atmospheric pressure CVD method was carried out as follows.

Monobutyl trichlorotin as a tin raw material and titanium tetraisopropoxide as a titanium raw materials were respectively heated and bubbled by using dry nitrogen in a heating bubbling tank, and predetermined amounts of raw materials together with the bubbling gas were taken out as vapor. Further, trifluoroacetic acid as a fluorine raw material was similarly heated and bubbled by using dry nitrogen in a heating bubbling tank while the supply amount was adjusted so that the proportion of trifluoroacetic acid/titanium tetraisopropoxide was 0.2 by the molar ratio. Such material gases were mixed with an oxygen gas and sprayed on the side where the fluorine-doped tin oxide film was formed of the substrate heated to 550°C to form an overcoat film 3 containing titanium oxide as the main component and containing, as tin oxide having favorable electrical conductivity, tin oxide containing fluorine as a dopant, as tin oxide, on the fluorine-doped tin oxide film.

Then, a step of patterning the transparent electrically conductive oxide film as the transparent electrode layer 2 and the overcoat film 3 was carried out by a laser scribing method by the following procedure to form a first dividing groove P1 in the transparent electrically conductive oxide film as the transparent electrode layer 2 and the overcoat film 3.

In this patterning step, using a pulse fiber laser at a wavelength of 1,064 nm as a light source, the substrate 1 was irradiated in one edge direction with focused 1.3 W laser light from the overcoat film 3 side with a repetition frequency of 10 kHz while the laser light was moved every 10 µm in a direction in parallel with the surface of the substrate, to form a linear first dividing groove P1 (i.e. a groove-form region where the transparent electrically conductive oxide film and the overcoat film were not present) having a width of about 26 µm in the transparent electrically conductive oxide film as the transparent electrode layer 2 and the overcoat film 3. This procedure was repeatedly carried out at intervals of about 10 mm in another edge direction of the substrate 1 to form linear first dividing grooves P1.

Then, on the overcoat film 3, an a-SiC:B layer (20 nm) as the p-layer, an a-Si:H layer (350 nm) as the i-layer and an a-Si:P layer (40 nm) as the n-layer were formed in this order by a plasma CVD method respectively by using SiH₄/CH₄/H₂/B₂ H₆, SiH₄/H₂ and SiH₄/H₂/PH₃ as raw material gases, to form a single structure photoelectric conversion layer 4 consisting of 3 layers of the p-layer, the i-layer and the n-layer formed in this order. In each raw material gas, "/" means "and", and for example, "SiH₄/H₂" (the raw material for the i-layer) means that SiH₄ and H₂ were used as the raw materials.

Then, a step of patterning the photoelectric conversion layer 4 was carried out by a laser scribing method by the following procedure to form a second dividing groove P2 in the photoelectric conversion layer 4.

In this patterning step, using a pulse fiber laser at a wavelength of 1,064 nm as a light source, a laser light having a wavelength of 532 nm which is the second higher harmonics of the laser light source was applied at an output of 144 mW from the rear side of the substrate 1 through the substrate 1 with a repetition frequency of 10 kHz, while the laser light was moved every 20 µm in a direction in parallel with the surface of the substrate. The energy distribution at the portion irradiated with the laser light was Gaussian distribution such that the light was merely focused.

The substrate 1 was irradiated in one edge direction with the laser light with a repetition frequency of 10 kHz at a position with a distance between central lines of 100 µm to the first dividing groove P1, while the laser light was moved every 10 µm in a direction in parallel with the surface of the substrate, to form a linear second dividing groove P2 (i.e. a groove-form region where the photoelectric conversion layer was not present) having a width of about 40 µm in the photoelectric conversion layer 4. Here, a sample prepared in the same manner was observed by a scanning electron microscope (SEM) and as a result, it was confirmed that in a region having a width of about 20 µm at a center portion of the second dividing groove P2, the transparent electrically conductive oxide film also disappeared, and the bottom of the second dividing groove P2 was located in the transparent electrically conductive oxide film. This operation was carried out for all the linear first dividing grooves P1 repeatedly formed at intervals of about 10 mm in another edge direction of the substrate 1 to form second dividing grooves P2 at positions 100 µm distant from the first dividing groove P1.

Then, a DC sputtering method was carried out to the substrate 1 at an angle of inclination of 60° using a GZO target containing Ga in an amount of 5 mol% to the total amount with zinc, to form a GZO layer as a contact-improving layer in a thickness of about 100 nm on the photoelectric conversion layer 4. Sputtering was carried out in such a manner that a vacuum apparatus was preliminarily depressurized to at most 10' ⁴ Pa, and then an Ar gas at a flow rate of 75 seem and a CO₂ gas at a flow rate of 1 seem were introduced to carry out sputtering, under a pressure during sputtering of 4×10⁻¹ Pa at a sputtering power of 2.4 W/cm². Further, the Ga content in the GZO film was 5 mol% to the total amount with zinc which was the same as the target, and the temperature of the substrate 1 was 100°C. The GZO single film had a specific resistance of 5×10⁻³ Ω·cm, and an absorption coefficient of 1×10³ cm⁻¹ at from 500 to 800 nm.

Then, on the GZO film, a Ag film as a rear electrode layer 5 was formed in a thickness of about 200 nm by a sputtering method (pressure during sputtering: 4×10⁻¹ Pa, sputtering power: 1.4 W/cm²) in an Ar gas atmosphere using a Ag target.

Then, a step of patterning the rear electrode layer 5 and the photoelectric conversion layer 4 was carried out by a laser scribing method by the following procedure to form a third dividing groove P3 in the rear electrode layer 5 and the photoelectric conversion layer 4.

In this patterning step, using a pulse fiber laser at a wavelength of 1,064 nm as a light source, laser light having a wavelength of 532 nm which is the second higher harmonics of the laser light source was irradiated at an output of 45 mW from the rear side of the substrate 1 through the substrate 1. The energy distribution at a portion irradiated with the laser light was Gaussian distribution such that the light was merely focused.

The substrate 1 was irradiated in one edge direction with the laser light at a position with a repetition frequency of 10 kHz with a distance between central lines of 100 µm to the second dividing groove P2 (i.e. at a position with a distance between central lines of 200 µm to the first dividing groove P1) while the laser light was moved every 30 µm in a direction in parallel with the surface of the substrate 1, to form a linear third dividing groove P3 (a groove-form region where the rear electrode layer and the photoelectric conversion layer were not present) having a width of about 33 µm in the rear electrode layer 5 and the photoelectric conversion layer 4. This procedure was repeatedly carried out to all the linear dividing grooves P2 repeatedly formed at intervals of about 10 mm in another edge direction of the substrate 1, to form third dividing grooves at positions 100 µm distant from the second dividing groove P2.

Then, at positions about 10 mm from both the edges of the substrate 1, in a direction vertical to the first dividing grooves, the second dividing grooves and the third dividing grooves, grooves to cut off and separate edge defective portions were formed on the film having the photoelectric conversion layer, the rear electrode layer, the overcoat film and the transparent electrically conductive oxide film laminated, by a laser scribing method, and these edge defective portions were electrically separated to prepare thin film solar cells. Since the substrate used had a size of 300 mm × 300 mm, about 28 cells having a size of 280 mm × 10 mm were formed in series. Hereafter, a rear protective film, etc. are formed as the case requires to produce a solar cell module.

Further, separately from the above, a sample having a structure as shown in Fig. 4 was prepared in the same process for the thin film solar cell module, as a sample for measurement of the resistance. However, as shown in Fig. 4, the first dividing groove P1 was not formed, and the positions of the second dividing groove P2 and the third dividing groove P3 were changed. The contact resistance at the second dividing groove P2 was measured using this sample. As shown in the left side in Fig. 4, the resistance of "rear electrode layer 5/second dividing groove P2/transparent electrode layer 2 (length: 5 mm)/second dividing groove P2/rear electrode layer 5" was measured by an ohmmeter 10, and as shown in the right side in Fig. 4, the resistance of "rear electrode layer 5/second dividing groove P2/transparent electrode layer 2 (length: 10 mm)/second dividing groove P2/rear electrode layer 5" was measured by an ohmmeter 11. The resistance of the transparent electrode layer 3 was obtained from the difference between the resistance in a case where the length of the transparent electrode layer 3 measured was 5 mm and the resistance in a case where it was 10 mm, and from the result, the resistance in a case where the length of the transparent electrode layer 3 was 0 mm was obtained by calculation, and the obtained resistance was divided by 2 to obtain the contact resistance at the second dividing groove P2. In Fig. 4, the ohmmeters were represented as two ohmmeters, however, the resistances are preferably measured by the same ohmmeter.

As a result, the contact resistance at the second dividing groove P2 was 3.4Ω calculated as a width of 10 mm.

Of the thin film solar cell module obtained by the above procedure, a wiring material such as a copper foil was jointed by soldering with both edges of the strip power generation regions connected in series, and the voltage/current properties were measured, and solar cell properties such as the conversion efficiency were measured, under irradiation with pseudo sunlight by a solar simulator, to obtain a I-V curve. The results are shown in Fig. 3.

### (Comparative Example 1)

The same operation as in Example was carried out except that in the step of patterning the photoelectric conversion layer 4, laser light having a wavelength of 532 nm was irradiated at an output of 41 mW from the rear side of the substrate 1 through the substrate 1. In the photoelectric conversion layer 4, linear second dividing grooves P2 (i.e. groove-form regions where the photoelectric conversion layer was not present) having a width of about 33 µm were formed. Further, a sample prepared in the same manner was observed by a scanning electron microscope (SEM) and as a result, the transparent electrically conductive oxide film under the overcoat film was not significantly damaged, and the overcoat film was observed by the SEM.

Also in Comparative Example 1, the contact resistance at the second dividing groove P2 was measured in the same manner as in Example, whereupon it was 49 Ω. Thus, it is considered that the resistance of the overcoat film at the portion where the second dividing groove P2 was formed was increased by the heat by the laser.

Further, a I-V curve was obtained in the same manner as in Example. The results are shown in Fig. 3.

### (Comparative Example 2)

The same operation as in Comparative Example 1 was carried out except that the overcoat film 3 was not formed on the transparent electrically conductive oxide film (fluorine-doped tin oxide film) as the transparent electrode layer 2.

Also in Comparative Example 2, the contact resistance at the second dividing groove P2 was measured in the same manner as in Example, whereupon it was 0.1 Ω.

Further, a I-V curve was obtained in the same manner as in Example. The results are shown in Fig. 3.

In Fig. 3, by comparison between Example regarding the thin film solar cell module in which the overcoat film 3 was formed on the transparent electrically conductive oxide film (fluorine-doped tin oxide film) as the transparent electrode layer 2, and Comparative Example 1, it is found that in Comparative Example 1 in which the contact resistance is high, the shape of the I-V curve falls down, thus indicating low power generation performance.

Further, it is considered that in Comparative Example 2 in which the overcoat film 3 was not formed on the transparent electrically conductive oxide film (fluorine-doped tin oxide film) as the transparent electrode layer 2, although the contact resistance was low, since there was no overcoat film which also functions as a refractive index-adjusting layer, no improvement in the light trapping efficiency was achieved, and the amount of incident light to the photoelectric conversion layer was small as compared with Example, thus leading to a small power generation amount and thus a low current.

Conditions and results in Example and Comparative Examples are shown in Table 1.

**Table 1**

| | Overcoat film | Laser output (wavelength: 532 nm) at the time of forming second dividing groove P2 | Power density of laser at the time of forming second dividing groove P2 | Resistance | Current of solar cell (based on Example) |
|---|---|---|---|---|---|
| Ex. | Present | 144mW | 0.115 mW/µm² | 3.4 Ω | Standard |
| Comp. Ex. 1 | Present | 41 mW | 0.047 mW/µm² | 49 Ω | Lower than standard |
| Comp. Ex. 2 | Nil | 41 mW | 0.047 mW/µm² | 0.1Ω | Lower than standard by absence of overcoat film |

As evident from table 1, it is considered that when the power density of the laser (wavelength: 532 nm) at the time of forming the second dividing groove P2 is higher than 0.1 mW/µm², the overcoat film is sufficiently cut, and the bottom of the second dividing groove is located in the transparent electrically conductive oxide film.

### INDUSTRIAL APPLICABILITY

According to the present invention, by laser scribing, even in a case where the overcoat film is heat-denatured and its resistance is increased, since the rear electrode layer formed in the second dividing groove of the thin film solar cell module and the transparent electrically conductive oxide film are electrically connected, electrical connection in series of the adjacent thin film solar cells is maintained, and the power loss by the resistance can be suppressed, and accordingly the efficiency as a thin film solar cell module will be improved.

### REFERENCE SYMBOLS

- 1:: Substrate
- 2:: Transparent electrode layer
- 3:: Overcoat film
- 4:: Photoelectric conversion layer
- 5:: Rear electrode layer
- P1:: First dividing groove
- P2:: Second dividing groove
- P3:: Third dividing groove
- 10,11:: Ohmmeter

## Claims

1. A process for producing a thin film solar cell module comprising a plurality of thin film solar cells each comprising a substrate (1), and a transparent electrically conductive oxide film (2), an overcoat film (3), a photoelectric conversion layer (4) and a rear electrode layer (5) laminated in this order on the substrate, the layers on the substrate being divided by a plurality of dividing grooves (P1,P2) in a direction substantially vertical to the substrate, and the adjacent thin film solar cells being electrically connected in series, the process comprising:
a step of forming the transparent electrically conductive oxide film (2) on the substrate, a step of forming the overcoat layer (3), on the transparent electrically conductive oxide film (2) and a step of patterning the transparent electrically conductive oxide film (2) and the overcoat film (3) by forming a first dividing groove (P1) in the transparent electrically conductive oxide film (2) and the overcoat film (3), by a laser scribing method to divide the transparent electrically conductive oxide film (2) and the overcoat layer (3);
a step of forming the photoelectric conversion layer (4) in the first dividing groove (P1) and on the overcoat film (31) and a step of patterning the photoelectric conversion layer (4) by forming a second dividing groove (P2) in the photoelectric conversion layer by a laser scribing method to divide the photoelectric conversion layer (4) and a step of forming the rear electrode layer (5) in the second dividing groove (P2) and on the photoelectric conversion layer (4) and a step of patterning the rear electrode layer (5) and the photoelectric conversion layer (4) by forming a third dividing groove (P3) in the rear electrode layer (5) and the photoelectric conversion layer (4) by a laser scribing method to divide the rear electrode layer (5) and the photoelectric conversion layer (4):
wherein the step of patterning the photoelectric conversion layer is carried out so that the bottom of the second dividing groove (P2) is located in the transparent electrically conductive oxide film (2); and
wherein the overcoat fim (3) is a film containing titanium oxide as the main component and containing tin oxide.

2. The process for producing a thin film solar cell module according to Claim 1, wherein the power density of laser light in the laser scribing method to form the second dividing groove in the photoelectric conversion layer is higher than 0.1 mW/µm².

3. The process for producing a thin film solar cell module according to Claim 1 or 2, wherein the rear electrode layer (5) and the transparent electrically conductive oxide film (2) are electrically connected in the second dividing groove (P2).

4. The process for producing a thin film solar cell module according to any one of Claims 1 to 3, wherein the transparent electrically conductive oxide film (2) is a tin oxide film containing fluorine as a dopant.

5. The process for producing a thin film solar cell module according to any one of Claims 1 to 4, wherein the thickness of the transparent electrically conductive oxide film is from 400 to 1,200 nm.

6. The process for producing a thin film solar cell module according to any one of Claims 1 to 5, wherein for formation of the transparent electrically conductive oxide film (2), an atmospheric pressure CVD method is used.

7. The process for producing a thin film solar cell module according to any one of Claims 1 to 6, wherein the thickness of the overcoat film is from 10 to 100 nm.

8. The process for producing a thin film solar cell module according to any one of Claims 1 to 7, wherein for formation of the overcoat film, an atmospheric pressure CVD method is used.

9. The process for producing a thin film solar cell module according to any one of Claims 1 to 8, wherein the photoelectric conversion layer contains a layer (p-i-n-layer) having a p-layer, an i-layer and a n-layer formed in this order.

10. The process for producing a thin film solar cell module according to any one of Claims 1 to 9, wherein for formation of the photoelectric conversion layer, a plasma CVD method is used.

11. The process for producing a thin film solar cell module according to any one of Claims 1 to 10, wherein the rear electrode layer contains as the main component silver, aluminum or an alloy thereof.

12. The process for producing a thin film solar cell module according to any one of Claims 1 to 11, wherein the thickness of the rear electrode layer is from 100 to 300 nm.

13. The process for producing a thin film solar cell module according to any one of Claims 1 to 12, wherein for formation of the rear electrode layer (5) a sputtering method is used.

14. The process for producing a thin film solar cell module according to any one of Claims 1 to 13, wherein the energy distribution at a portion irradiated with the laser light at the time of forming the second dividing groove, is Gaussian distribution.

15. The process for producing a thin film solar cell module according to any one of Claims 1 to 14, wherein in the step of patterning the transparent electrically conductive oxide film (2) and the overcoat film (3), in the step of patterning the photoelectric conversion layer (4) and in the step of patterning the rear electrode layer (5) and the photoelectric conversion layer, (4), a laser light source at an oscillation wavelength in the vicinity of 1,064 nm is used.

16. A thin film solar cell module which comprises a plurality of thin film solar cells each comprising a substrate (1), and a transparent electrically conductive oxide film (2), an overcoat film (3), a photoelectric conversion layer (4) and a rear electrode layer (5) laminated in this order on the substrate (1), the layers on the substrate being divided by dividing grooves (P1,P2,P3) and the adjacent thin film solar cells being electrically connected in series, wherein the transparent electrically conductive oxide film (2) and the overcoat layer (3) are divided by a first dividing groove (P1), the photoelectric conversion layer (4) is embedded in the first dividing groove (P1), the photoelectric conversion layer (4) is divided by a second dividing groove (P2), the rear electrode layer (5) is embedded in the second dividing groove (P1), the rear electrode layer (5) and the photoelectric conversion layer (4) are divided by a third dividing groove (13), and the bottom of the second dividing groove (P2) is located in the transparent electrically conductive oxide film (2), **characterised in that** the overcoat film (3) is a film containing titanium oxide as the main component and containing tin oxide.

17. The thin film solar cell module according to Claim 17, wherein the rear electrode layer (5) and the transparent electrically conductive oxide film (2) are electrically connected in the second dividing groove.

## Patentansprüche

1. Verfahren zur Herstellung eines Dünnschichtsolarzellenmoduls, umfassend eine Mehrzahl an Dünnschichtsolarzellen, welche jeweils ein Substrat (1), und einen transparenten, elektrisch leitfähigen Oxidfilm (2), einen Deckschichtfilm (3), eine photoelektrische Konversionsschicht (4) und eine hintere Elektrodenschicht (5), die in dieser Reihenfolge auf dem Substrat laminiert werden, umfassen, wobei die Schichten auf dem Substrat durch eine Mehrzahl an Teilungsrillen (P1, P2) in einer Richtung, die im Wesentlichen vertikal zum Substrat ist, geteilt sind, und die benachbarten Dünnschichtsolarzellen in Serie elektrisch verbunden sind, das Verfahren umfassend:
einen Schritt des Bildens des transparenten, elektrisch leitfähigen Oxidfilms (2) auf dem Substrat, einen Schritt des Bildens des Deckschichtfilms (3) auf dem transparenten, elektrisch leitfähigen Oxidfilm (2), und einen Schritt des Strukturierens des transparenten, elektrisch leitfähigen Oxidfilms (2) und des Deckschichtfilms (3) durch das Bilden einer ersten Teilungsrille (P1) in dem transparenten, elektrisch leitfähigen Oxidfilm (2) und dem Deckschichtfilm (3) durch ein Laserstrukturierungsverfahren, um den transparenten, elektrisch leitfähigen Oxidfilm (2) und den Deckschichtfilm (3) zu teilen,
einen Schritt des Bildens der photoelektrischen Konversionsschicht (4) in der ersten Teilungsrille (P1) und auf dem Deckschichtfilm (3) und einen Schritt des Strukturierens der photoelektrischen Konversionsschicht (4) durch das Bilden einer zweiten Teilungsrille (P2) in der photoelektrischen Konversionsschicht durch ein Laserstrukturierungsverfahren, um die photoelektrische Konversionsschicht (4) zu teilen und
einen Schritt des Bildens der hinteren Elektrodenschicht (5) in der zweiten Teilungsrille (P2) und auf der photoelektrischen Konversionsschicht (4) und einen Schritt des Strukturierens der hinteren Elektrodenschicht (5) und der photoelektrischen Konversionsschicht (4) durch das Bilden einer dritten Teilungsrille (P3) in der hinteren Elektrodenschicht (5) und der photoelektrischen Konversionsschicht (4) durch ein Laserstrukturierungsverfahren, um die hintere Elektrodenschicht (5) und die photoelektrische Konversionsschicht (4) zu teilen,
wobei der Schritt des Strukturierens der photoelektrischen Konversionsschicht so ausgeführt wird, dass sich der Boden der zweiten Teilungsrille (P2) in dem transparenten, elektrisch leitfähigen Oxidfilm (2) befindet, und
wobei der Deckschichtfilm (3) ein Film ist, der Titanoxid als Hauptkomponente enthält und Zinnoxid enthält.

2. Verfahren zur Herstellung eines Dünnschichtsolarzellenmoduls nach Anspruch 1, wobei die Energiedichte von Laserlicht in dem Laserstrukturierungsverfahren zur Bildung der zweiten Teilungsrille in der photoelektrischen Konversionsschicht größer als 0,1 mW/µm² ist.

3. Verfahren zur Herstellung eines Dünnschichtsolarzellenmoduls nach Anspruch 1 oder 2, wobei die hintere Elektrodenschicht (5) und der transparente, elektrisch leitfähige Oxidfilm (2) in der zweiten Teilungsrille (P2) elektrisch verbunden sind.

4. Verfahren zur Herstellung eines Dünnschichtsolarzellenmoduls nach einem der Ansprüche 1 bis 3, wobei der transparente, elektrisch leitfähige Oxidfilm (2) ein Zinnoxidfilm ist, der Fluor als Dotanden enthält.

5. Verfahren zur Herstellung eines Dünnschichtsolarzellenmoduls nach einem der Ansprüche 1 bis 4, wobei die Dicke des transparenten, elektrisch leitfähigen Oxidfilms von 400 bis 1200 nm beträgt.

6. Verfahren zur Herstellung eines Dünnschichtsolarzellenmoduls nach einem der Ansprüche 1 bis 5, wobei zur Bildung des transparenten, elektrisch leitfähigen Oxidfilms (2) ein Atmosphärendruck-CVD-Verfahren verwendet wird.

7. Verfahren zur Herstellung eines Dünnschichtsolarzellenmoduls nach einem der Ansprüche 1 bis 6, wobei die Dicke des Deckschichtfilms von 10 bis 100 nm beträgt.

8. Verfahren zur Herstellung eines Dünnschichtsolarzellenmoduls nach einem der Ansprüche 1 bis 7, wobei zur Bildung des Deckschichtfilms ein Atmosphärendruck-CVD-Verfahren verwendet wird.

9. Verfahren zur Herstellung eines Dünnschichtsolarzellenmoduls nach einem der Ansprüche 1 bis 8, wobei die photoelektrische Konversionsschicht eine Schicht (p-i-n-Schicht) mit einer p-Schicht, einer i-Schicht und einer n-Schicht, gebildet in dieser Reihenfolge, enthält.

10. Verfahren zur Herstellung eines Dünnschichtsolarzellenmoduls nach einem der Ansprüche 1 bis 9, wobei zur Bildung der photoelektrischen Konversionsschicht ein Plasma-CVD-Verfahren verwendet wird.

11. Verfahren zur Herstellung eines Dünnschichtsolarzellenmoduls nach einem der Ansprüche 1 bis 10, wobei die hintere Elektrodenschicht als Hauptkomponente Silber, Aluminium oder eine Legierung davon enthält.

12. Verfahren zur Herstellung eines Dünnschichtsolarzellenmoduls nach einem der Ansprüche 1 bis 11, wobei die Dicke der hinteren Elektrodenschicht von 100 bis 300 nm beträgt.

13. Verfahren zur Herstellung eines Dünnschichtsolarzellenmöduls nach einem der Ansprüche 1 bis 12, wobei zur Bildung der hinteren Elektrodenschicht (5) ein Sputterverfahren verwendet wird.

14. Verfahren zur Herstellung eines Dünnschichtsolarzellenmoduls nach einem der Ansprüche 1 bis 13, wobei die Energieverteilung an einem Bereich, der mit dem Laserlicht zum Zeitpunkt der Bildung der zweiten Teilungsrille bestrahlt wird, eine Gauß-Verteilung ist.

15. Verfahren zur Herstellung eines Dünnschichtsolarzellenmoduls nach einem der Ansprüche 1 bis 14, wobei in dem Schritt des Strukturierens des transparenten, elektrisch leitfähigen Oxidfilms (2) und des Deckschichtfilms (3), in dem Schritt des Strukturierens der photoelektrischen Konversionsschicht (4) und in dem Schritt des Strukturierens der hinteren Elektrodenschicht (5) und der photoelektrischen Konversionsschicht (4) eine Laserlichtquelle bei einer Oszillationswellenlänge in der Nähe von 1064 nm verwendet wird.

16. Dünnschichtsolarzellenmodul, umfassend eine Mehrzahl an Dünnschichtsolarzellen, welche jeweils ein Substrat (1), und einen transparenten, elektrisch leitfähigen Oxidfilm (2), einen Deckschichtfilm (3), eine photoelektrische Konversionsschicht (4) und eine hintere Elektrodenschicht (5), die in dieser Reihenfolge auf dem Substrat (1) laminiert sind, umfassen, wobei die Schichten auf dem Substrat durch eine Mehrzahl an Teilungsrillen (P1, P2, P3) geteilt sind und die benachbarten Dünnschichtsolarzellen in Serie elektrisch verbunden sind, wobei der transparente, elektrisch leitfähige Oxidfilm (2) und der Deckschichtfilm (3) durch eine erste Teilungsrille (P1) geteilt sind, die photoelektrische Konversionsschicht (4) in der ersten Teilungsrille (P1) eingebettet ist, die photoelektrische Konversionsschicht (4) durch eine zweite Teilungsrille (P2) geteilt ist, die hintere Elektrodenschicht (5) in der zweiten Teilungsrille (P2) eingebettet ist, die hintere Elektrodenschicht (5) und die photoelektrische Konversionsschicht (4) durch eine dritte Teilungsrille (P3) geteilt sind und sich der Boden der zweiten Teilungsrille (P2) in dem transparenten, elektrisch leitfähigen Oxidfilm (2) befindet, **dadurch gekennzeichnet, dass**
der Deckschichtfilm (3) ein Film ist, der Titanoxid als Hauptkomponente enthält und Zinnoxid enthält.

17. Dünnschichtsolarzellenmodul nach Anspruch 17, wobei die hintere Elektrodenschicht (5) und der transparente, elektrisch leitfähige Oxidfilm (2) in der zweiten Teilungsrille elektrisch verbunden sind.

## Revendications

1. Procédé de production d'un module de cellule solaire en film mince comprenant une pluralité des cellules solaires en film mince, chacune comprenant un substrat (1) et un film d'oxyde électriquement conducteur transparent (2), un film de revêtement (3), une couche de conversion photoélectrique (4) et une couche d'électrode arrière (5) agencées en couches sel
on cet ordre sur le substrat, les couches sur le substrat étant divisées par une pluralité de rainures de division (P1, P2) dans une direction sensiblement verticale par rapport au substrat, et les cellules solaires en film mince adjacentes étant raccordées électriquement en série, le procédé comprenant :
une étape de formation du film d'oxyde électriquement conducteur transparent (2) sur le substrat, une étape de formation de la couche de revêtement (3) sur le film d'oxyde électriquement conducteur transparent (2) et une étape de formation de motif sur le film d'oxyde électriquement conducteur transparent (2) et le film de revêtement (3) en formant une première rainure de division (P1) sur le film d'oxyde électriquement conducteur transparent (2) et le film de revêtement (3) par une opération d'écriture au laser afin de diviser le film d'oxyde électriquement conducteur transparent (2) et la couche de revêtement (3) ;
une étape de formation de la couche de conversion photoélectrique (4) sur la première rainure de division (P1) et sur le film de revêtement (3) et une étape de formation de motif sur la couche de conversion photoélectrique (4) en formant une deuxième rainure de division (P2) sur la couche de conversion photoélectrique par une opération d'écriture au laser afin de diviser la couche de conversion photoélectrique (4) et une étape de formation de la couche d'électrode arrière (5) sur la deuxième rainure de division (P2) et sur la couche de conversion photoélectrique (4), et une étape de formation de motif sur la couche d'électrode arrière (5) et la couche de conversion photoélectrique (4) en formant une troisième rainure de division (P3) sur la couche d'électrode arrière (5) et la couche de conversion photoélectrique (4) par une opération d'écriture au laser afin de diviser la couche d'électrode arrière (5) et la couche de conversion photoélectrique (4) ;
dans lequel l'étape de formation de motif sur la couche de conversion photoélectrique est mise en oeuvre de telle sorte que le fond de la deuxième rainure de division (P2) se situe sur le film d'oxyde électriquement conducteur transparent (2) ; et
dans lequel le film de revêtement (3) est un film contenant de l'oxyde de titane pour le composant principal et contenant de l'oxyde d'étain.

2. Procédé de production d'un module de cellule solaire en film mince selon la revendication 1, dans lequel la densité d'énergie de la lumière laser dans l'opération d'écriture au laser destinée à former la deuxième rainure de division dans la couche de conversion photoélectrique est supérieure à 0,1 mW/µm2.

3. Procédé de production d'un module de cellule solaire en film mince selon la revendication 1 ou 2, dans lequel la couche d'électrode arrière (5) et le film d'oxyde électriquement conducteur transparent (2) sont raccordés électriquement dans la deuxième rainure de division (P2).

4. Procédé de production d'un module de cellule solaire en film mince selon l'une quelconque des revendications 1 à 3, dans lequel le film d'oxyde électriquement conducteur transparent (2) est un film d'oxyde d'étain contenant du fluor en tant que dopant.

5. Procédé de production d'un module de cellule solaire en film mince selon l'une quelconque des revendications 1 à 4, dans lequel l'épaisseur du film d'oxyde électriquement conducteur transparent est comprise entre 400 et 1200 nm.

6. Procédé de production d'un module de cellule solaire en film mince selon l'une quelconque des revendications 1 à 5, dans lequel, pour la formation du film d'oxyde électriquement conducteur transparent (2), un traitement par dépôt CVD sous pression atmosphérique est utilisé.

7. Procédé de production d'un module de cellule solaire en film mince selon l'une quelconque des revendications 1 à 6, dans lequel l'épaisseur du film de revêtement est comprise entre 10 et 100 nm.

8. Procédé de production d'un module de cellule solaire en film mince selon l'une quelconque des revendications 1 à 7, dans lequel, pour la formation du film de revêtement, un traitement par dépôt CVD sous pression atmosphérique est utilisé.

9. Procédé de production d'un module de cellule solaire en film mince selon l'une quelconque des revendications 1 à 8, dans lequel la couche de conversion photoélectrique contient une couche (couche p-i-n) comportant une couche p, une couche i et une couche n formées selon cet ordre.

10. Procédé de production d'un module de cellule solaire en film mince selon l'une quelconque des revendications 1 à 9, dans lequel, pour la formation de la couche de conversion photoélectrique, un traitement par dépôt CVD sous plasma est utilisé.

11. Procédé de production d'un module de cellule solaire en film mince selon l'une quelconque des revendications 1 à 10, dans lequel la couche d'électrode arrière contient, pour le composant principal, de l'argent, de l'aluminium ou un alliage de ceux-ci.

12. Procédé de production d'un module de cellule solaire en film mince selon l'une quelconque des revendications 1 à 11, dans lequel l'épaisseur de la couche d'électrode arrière est comprise entre 100 et 300 nm.

13. Procédé de production d'un module de cellule solaire en film mince selon l'une quelconque des revendications 1 à 12, dans lequel pour la formation de la couche d'électrode arrière (5) un procédé par pulvérisation est utilisé.

14. Procédé de production d'un module de cellule solaire en film mince selon l'une quelconque des revendications 1 à 13, dans lequel la distribution d'énergie au niveau d'une partie soumise à la lumière laser au moment de la formation de la deuxième rainure de division, est une distribution gaussienne.

15. Procédé de production d'un module de cellule solaire en film mince selon l'une quelconque des revendications 1 à 14, dans lequel, à l'étape de formation de motif sur le film d'oxyde électriquement conducteur transparent (2) et le film de revêtement (3), à l'étape de formation de motif sur la couche de conversion photoélectrique (4) et à l'étape de formation de motif sur la couche d'électrode arrière (5) et la couche de conversion photoélectrique (4), une source de lumière laser présentant une longueur d'onde d'oscillation proche de 1064 nm est utilisée.

16. Module de cellule solaire en film mince qui comprend une pluralité de cellules solaires en film mince comprenant chacune un substrat (1) et un film d'oxyde électriquement conducteur transparent (2), un film de revêtement (3), une couche de conversion photoélectrique (4) et une couche d'électrode arrière (5) agencés en couches selon cet ordre sur le substrat (1), les couches sur le substrat étant divisées par des rainures de division (P1, P2, P3) et les cellules solaires en film mince adjacentes étant raccordées électriquement en série, dans lequel le film d'oxyde électriquement conducteur transparent (2) et la couche de revêtement (3) sont divisés par une première rainure de division (P1), la couche de conversion photoélectrique (4) est noyée dans la première rainure de division (P1), la couche de conversion photoélectrique (4) est divisée par une deuxième rainure de division (P2), la couche d'électrode arrière (5) est noyée dans la deuxième rainure de division (P2), la couche d'électrode arrière (5) et la couche de conversion photoélectrique (4) sont divisées par une troisième rainure de division (P3), et le fond de la deuxième rainure de division (P2) est situé sur le film d'oxyde électriquement conducteur transparent (2), **caractérisé en ce que**
le film de revêtement (3) est un film contenant de l'oxyde de titane pour le composant principal et contenant de l'oxyde d'étain.

17. Module de cellule solaire en film mince selon la revendication 16, dans lequel la couche d'électrode arrière (5) et le film d'oxyde électriquement conducteur transparent (2) sont raccordés électriquement dans la deuxième rainure de division.
